## Europäisches Patentamt
## European Patent Office
## Office européen des brevets

(19)

(11) Numéro de publication: **0 119 904**
**A1**

(12)
# DEMANDE DE BREVET EUROPEEN

(21) Numéro de dépôt: 84400440.8

(22) Date de dépôt: 06.03.84

(51) Int. Cl.³: **H 03 K 17/04**

(30) Priorité: 15.03.83 FR 8304240

(43) Date de publication de la demande: 26.09.84
Bulletin 84/39

(84) Etats contractants désignés: **DE FR GB IT NL SE**

(71) Demandeur: **THOMSON-CSF, 173, Boulevard Haussmann, F-75379 Paris Cedex 08 (FR)**

(72) Inventeur: **Rischmüller, Klaus, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

(54) **Circuit de commande de base en pont d'un transistor de puissance.**

(57) La présente invention concerne un circuit permettant de commander en commutation très rapidement un transistor de puissance (T). Ce circuit est du type inverseur en pont. Chacun des courants de base positif ($I_{B1}$) et négatif ($I_{B2}$) est déterminé et limité par une source de courant (respectivement T4, R5, R6, R7 et T2, R2, R3, R4). Ainsi, les transistors de ces sources de courant fonctionnant à un état non saturé peuvent être commutés très rapidement. Ce circuit permet de faire fonctionner en commutation avec des facteurs de forme variable un transistor de puissance à des fréquences de l'ordre de 10 à 100 kHz.

ACTORUM AG

# CIRCUIT DE COMMANDE DE BASE EN PONT D'UN TRANSISTOR DE PUISSANCE.

La présente invention concerne la commande en commutation des transistors de puissance à des fréquences élevées, par exemple dans la gamme de 10 à 100 kHz, qui permettent de choisir librement le rapport cyclique de conduction et de coupure du transistor de puissance.

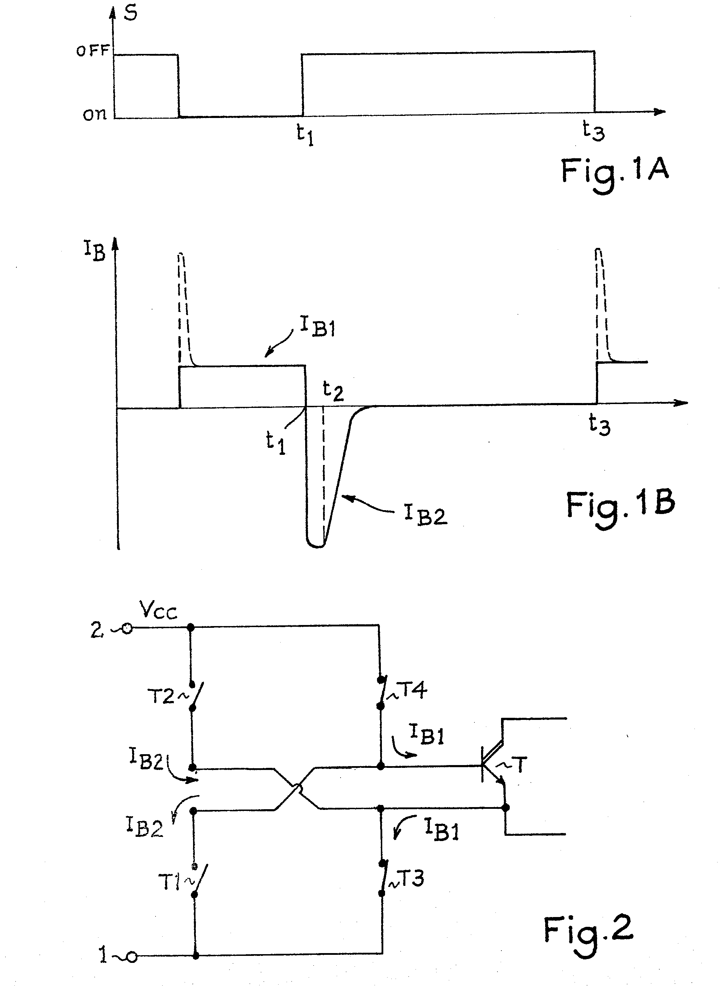

Etant donné un signal d'ordre de commutation S (figure 1A) susceptible de passer d'un premier état ou état "off" à un deuxième état ou état "on" selon que l'on souhaite qu'un transistor de puissance à commander soit bloqué ou conducteur, il est connu que, si l'on souhaite que les commutations d'un état à l'autre du transistor de puissance soient très rapides, il faut que le signal de base ait l'allure représentée en figure 1B. Comme le montre la figure 1B, le courant de base $I_B$ vers le transistor de puissance doit être d'une première polarité (par exemple $I_{B1}$ positif dans le cas où le transistor de puissance est un transistor NPN) quand l'on veut que ce transistor conduise, puis à l'instant où le signal d'ordre S passe de son état "on" à son état "off", il ne suffit pas d'interrompre le courant de base $I_B$, mais il faut extraire du transistor de puissance un courant d'une seconde polarité ($I_{B2}$ négatif dans le cas d'un transistor NPN) jusqu'à ce que les charges stockées dans ce transistor soient éliminées.

A priori, pour atteindre ce but, il faut disposer de deux sources d'alimentation de polarités opposées. Ceci constitue un inconvénient évident et l'on a cherché à réaliser des circuits de commande de base du type pouvant fournir des courants de base positif et négatif à partir d'une source de tension unique. Pour atteindre ce résultat, on a proposé d'utiliser des circuits dans lesquels l'une des sources, celle devant fournir le bref courant de base négatif, est remplacée par un condensateur ou une inductance. Toutefois, ces circuits souffrent d'un inconvénient important : pour que le condensateur ou l'inductance soit suffisament

2

charge, il faut que l'instant de coupure soit précédé d'une période de charge non nulle. Si la durée de conduction précédant l'instant de coupure est inférieure à ce temps de charge, le circuit ne fonctionne pas de façon satisfaisante. On ne pourra donc pas avec ce type de circuit réaliser des convertisseurs ou des alimentations à découpage ayant des rapports cycliques largement variables. Un autre inconvénient de ces circuits à condensateur ou à inductance est que ces composants sont difficilement intégrables et donc que ces circuits peuvent difficilement être réalisés sous forme entièrement intégrée.

Ainsi, la présente invention prévoit un circuit de commande de base pour transistor de puissance qui comprenne une seule source d'alimentation et dont le rapport cyclique puisse être largement variable.

Pour atteindre ce résultat, la présente invention propose l'utilisation d'un pont inverseur commandé pour appliquer alternativement des signaux de base de polarités opposées à un transistor de puissance en réponse aux changements d'état d'un signal d'ordre de commutation.

Dans la technique antérieure, on n'a pas utilisé d'inverseur en pont pour la commande de base de transistors de puissance devant fonctionner à des fréquences élevées, par exemple de l'ordre de 10 à 100 kHz. Ceci est dû au fait que les montages d'inverseur en pont classiques sont commandés de sorte que les inversions de courant ne sont pas immédiates et des chemins parasites de conduction peuvent se créer lors des commutations.

Ainsi, la présente invention prévoit un type de pont particulier et un mode de commande particulier de ce pont pour permettre la commande de base d'un transistor de la façon indiquée précédemment.

Le circuit de commande de base de transistor de puissance selon la présente invention permet, quand un signal d'ordre de commutation est dans un premier état, d'appliquer au transistor de puissance un courant de base d'une première polarité pour que le transistor de puissance soit conducteur, puis, quand ce signal d'ordre passe du premier état à un deuxième état, d'appliquer au

3

transistor de puissance un courant de base d'une seconde polarité pour le bloquer rapidement. Ce circuit de commande est alimenté par une source de tension unique. Le courant de base de la première polarité est fourni par une première source de courant connectée, d'une part, à la source d'alimentation, d'autre part à la base du transistor de puissance dont l'émetteur est relié à un premier transistor interrupteur. Le courant de base de la seconde polarité est fourni par une deuxième source de courant connectée, d'une part, à la source d'alimentation, d'autre part, à l'émetteur du transistor de puissance dont la base est reliée à un deuxième transistor interrupteur. Le premier transistor interrupteur est en série avec le circuit de polarisation de la première source de courant. Le deuxième transistor interrupteur est en série avec le circuit de polarisation de la deuxième source de courant. Le deuxième transistor interrupteur reçoit le signal d'ordre de commutation et est connecté au premier transistor interrupteur pour que leurs états soient complémentaires.

Ces objets, caractéristiques et avantages ainsi que d'autres de la présente invention seront exposés plus en détail dans la description suivante de modes de réalisation particuliers et faite en relation avec les figures jointes parmi lesquelles :

- les figures 1A et 1B décrites précédemment indiquent les signaux reçus et à fournir par un circuit de commande de base de transistor de puissance ;

- la figure 2 représente de façon très schématique une commande par pont inverseur d'un transistor de puissance et est destinée à illustrer le problème posé et résolu par la présente invention ;

- la figure 3 représente un circuit constituant un mode de réalisation fondamental de la présente invention ; et

- la figure 4 représente une variante de réalisation de la présente invention comportant également des composants supplémentaires pour atteindre d'autres fonctions que celles déjà réalisées par le circuit de la figure 3.

Tous les exemples suivants seront donnés dans le cas où le transistor de puissance à commander est du type NPN.

4

Ainsi, la figure 2 représente un transistor de puissance T, qui est généralement constitué d'une association de deux transistors en montage Darlington comme le montre le double trait au niveau du collecteur dans la représentation de la figure. Le circuit de commande est connecté entre des bornes d'alimentation 1 et 2, la borne 1 étant par exemple à la masse et la borne 2 à un potentiel positif Vcc. Quatre transistors T1 à T4 sont connectés en pont. Quand les interrupteurs constitués par les transistors T4 et T3 sont fermés alors que les interrupteurs constitués par les transistors T1 et T2 sont ouverts, un courant $I_{B1}$ circule de la source d'alimentation Vcc par le transistor T4 vers la base puis l'émetteur du transistor T en direction de la masse (borne 1) par l'intermédiaire du transistor T3. Dans cet état, on dira qu'un courant positif $I_{B1}$ est appliqué à la base du transistor de puissance et celui-ci est conducteur. Quand les interrupteurs correspondant aux transistors T1 et T2 sont fermés alors que les interrupteurs correspondant aux transistors T3 et T4 sont ouverts, un courant circule depuis l'alimentation Vcc par l'interrupteur T2, l'émetteur du transistor T, la base de ce transistor et l'interrupteur T1 vers la masse. Le courant circule de l'émetteur vers la base dans le transistor de puissance. On dit qu'un courant négatif $I_{B2}$ est appliqué à la base.

Une difficulté d'emploi de tels montages en pont réside dans le fait que pour l'application à la commande de base d'un transistor de puissance à fréquence élevée, il convient que les transitions d'une branche de conduction à l'autre soient extrêmement rapides. Par exemple, elles doivent être nettement inférieures à la microseconde si la fréquence de fonctionnement envisagée est de l'ordre de 50 kHz (période 20 microsecondes). Ainsi, il faut d'une part passer très rapidement de la fermeture des transistors T1 et T2 à celle des transistors T3 et T4 et inversement. D'autre part il faut éviter de passer par une phase de fermeture ou d'ouverture simultanée qui pourrait entraîner une destruction du transistor de puissance qui est particulièrement sensible quand il ne reçoit pas de courant de base. En outre, si par exemple les transistors T2 et T3 ou les transistors T1 et

T4 se trouvent fermés simultanément, un courant important va circuler dans le circuit de commande de base lui-même, ce courant de court-circuit entraînant des pertes importantes. Rappelons pour fixer des ordres de grandeur que le courant de base à appliquer au transistor principal peut être de quelques ampères.

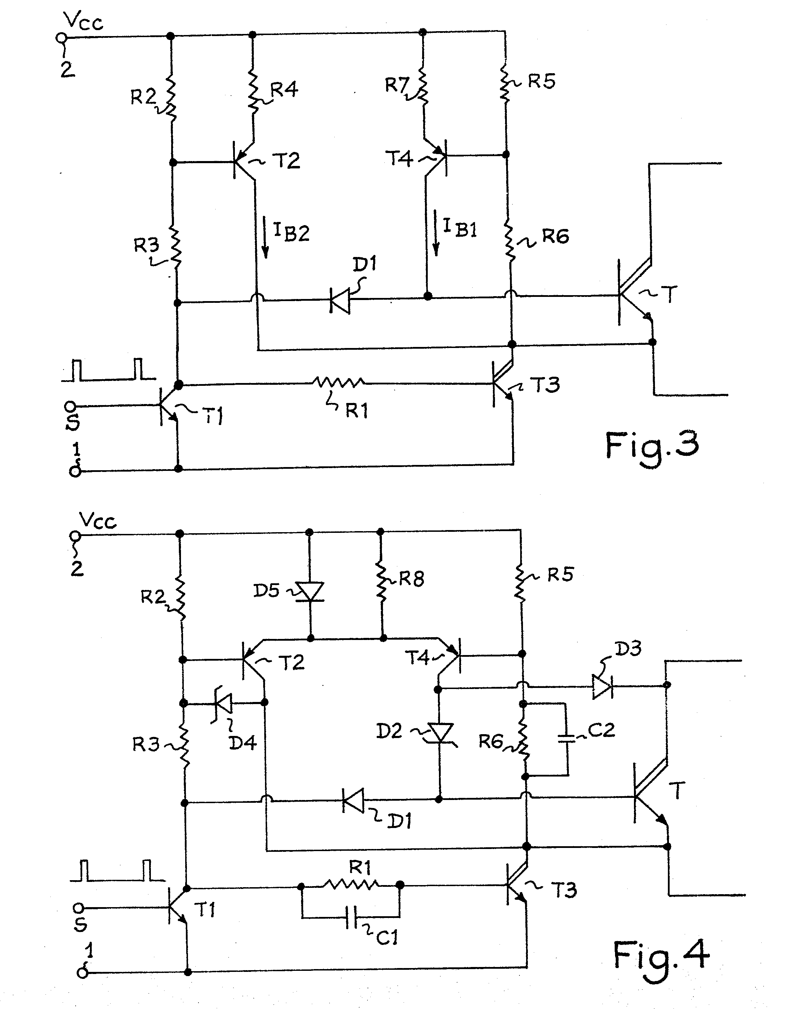

La figure 3 représente de façon simplifiée un mode de réalisation de la présente invention. Le circuit de commande de base est connecté aux bornes 1 et 2 d'une source d'alimentation unique, la borne 1 étant à la masse et la borne 2 à un potentiel +Vcc. Les transistors T1 et T3 sont des transistors NPN et les transistors T2 et T4 sont des transistors PNP.

Le transistor T1 reçoit sur sa base le signal d'ordre de commutation S qui varie entre un état haut assurant la mise en conduction du transistor T1 et un état bas assurant la coupure de ce transistor. L'émetteur du transistor T1 est connecté à la borne 1 et son collecteur est relié à la base du transistor de puissance T par l'intermédiaire d'une diode D1 polarisée de façon à permettre la circulation d'un courant depuis la base vers la masse par l'intermédiaire du transistor T1.

Le transistor T3 a sa base connectée au collecteur du transistor T1 par l'intermédiaire d'une résistance R1, son émetteur relié à la masse et son collecteur relié à l'émetteur du transistor principal T.

Les transistors T2 et T4 sont connectés en sources de courant. La base du transistor T2 est reliée au potentiel d'alimentation Vcc par une résistance R2, et au collecteur du transistor T1 par une résistance R3. L'émetteur du transistor T2 est relié à la tension d'alimentation par l'intermédiaire d'une résistance R4 et son collecteur à l'émetteur du transistor de puissance T. La base du transistor T4 est reliée au potentiel d'alimentation Vcc par une résistance R5 et au collecteur du transistor T3 par une résistance R6. L'émetteur du transistor T4 est relié au potentiel d'alimentation par l'intermédiaire d'une résistance R7 tandis que le collecteur de ce transistor T4 est relié à la base du transistor T. Les résistances R4 et R7 sont de faible valeur, par exemple de l'ordre de l'ohm, de façon à laisser

6

passer sans dissipation excessive un courant de commande de base positif ou négatif vers le transistor de puissance T.

Un aspect important de la présente invention réside dans le fait que les transistors T2 et T4 sont montés en source de courant. Ceci présente au moins deux avantages. Le premier est que des transistors dans une telle configuration peuvent être choisis pour fonctionner dans leur régime linéaire (non saturé) et alors, comme cela est bien connu, ils sont commutables à l'ouverture beaucoup plus rapidement que s'ils étaient à l'état saturé. Un autre avantage est que les valeurs des courants dans les transistors T2 et T4 ne dépendent que des valeurs des résistances de polarisation et d'émetteur de ces transistors ; ainsi, si les résistances R4 et R7 sont égales et de l'ordre de l'ohm, les résistances R3 et R6 également égales et de l'ordre de la centaine d'ohms, on pourra choisir les valeurs relatives des courants de base positif et négatif par le choix des valeurs des résistances R2 et R5. Ainsi, si l'on souhaite que le courant de base négatif $I_{B2}$ qui circule par le transistor T2 soit quatre fois plus intense que le courant de base positif $I_{B1}$ qui circule par le transistor T4, il suffit de choisir R2 sensiblement quatre fois supérieur à R5.

Pour que le circuit de commande de base décrit précédemment fonctionne de façon satisfaisante, il faut que le transistor T3 soit nettement plus sensible que le transistor T2.

Pour expliquer le fonctionnement du circuit selon l'invention, on considérera d'abord le cas où le signal d'ordre de commutation S sur la base du transistor T1 est à bas niveau. Ce transistor est alors bloqué. Etant donné les valeurs choisies pour les résistances de polarisation R2, R3 et R1 ainsi que les sensibilités différentes des transistors T2 et T3, le transistor T2 est bloqué et le transistor T3 conduit. Du fait de cette conduction, la polarisation de la base du transistor T4 est telle que ce transistor conduit également. Il circule alors un courant de base positif $I_{B1}$ depuis la borne 2, par la résistance R7, le transistor T4 et la jonction base/émetteur du transistor de puissance T, vers la borne de masse 1 par l'intermédiaire du transistor T3.

7

Le transistor de puissance T est alors conducteur. Quand à l'instant tl (voir figures 1A et 1B), le signal d'ordre S à l'entrée du transistor T1 passe à haut niveau, ce transistor devient conducteur. Le transistor T3 se bloque et le transistor T4 qui se trouve dans un régime non saturé se bloque également très rapidement tandis que le transistor T2 devient conducteur. Il circule alors un courant $I_{B2}$ depuis la borne 2 par la résistance R4 et le transistor T2 vers la jonction émetteur/base du transistor de puissance T, puis par la diode D1 et le transistor T1 vers la borne de masse 1. Comme le montre la figure 1B, ce courant se maintient pendant une courte durée tl-t2, puis décroît rapidement vers zéro tandis que la jonction émetteur/base du transistor T devient bloquante du fait que les charges stockées dans la base du transistor de puissance sont éliminées. Ensuite, à l'instant t3, le signal d'ordre S revient à bas niveau, et l'on revient à l'état précédent, le transistor T1 se bloquant ce qui entraîne le blocage très rapide du transistor T2 connecté en source de courant et la mise en conduction des transistors T3 et T4.

La figure 4 reprend le schéma électrique de la figure 3 en y apportant quelques modifications pour en améliorer le fonctionnement.

Les seuls éléments supprimés par rapport à la figure 3 sont les résistances d'émetteur R4 et R7 des transistors T2 et T4 qui sont remplacées par une résistance unique R8 disposée entre la source d'alimentation Vcc et une borne commune aux émetteurs des transistors T2 et T4. Cette modification a pour but d'agencer les transistors T2 et T4 dans un montage du type bascule qui rend encore plus incompatible leur conduction simultanée.

Un condensateur C1 est placé en parallèle avec la résistance R1 reliée à la base du transistor T3. Ceci a pour but d'introduire dans la base du transistor T3 au moment des commutations du transistor T1 une surintensité positive ou négative destinée à accélérer la mise en conduction ou le blocage du transistor T3.

Un condensateur C2 est disposé en parallèle sur la résistance de polarisation R6 du transistor T4. Ce condensateur a

8

pour but d'accélérer également la conduction et le blocage de ce transistor, mais aussi de provoquer une surintensité dans le courant de base positif $I_{B1}$ lors de la fermeture du transistor T4. Cette surintensité correspond à la portion de courbe en pointillés indiquée en figure 1B, par exemple à l'instant t3.

Une diode Schottky D2 et une diode de redressement D3 connectées entre la base et le collecteur du transistor T de la façon représentée servent de circuit d'anti-saturation pour ce transistor de puissance. De même, une diode Schottky D4 disposée entre la base et le collecteur du transistor T2 sert à protéger ce transistor contre une saturation éventuelle. On peut aussi prévoir une diode D5 en parallèle sur la résistance R8 si l'on souhaite faire fonctionner le circuit sans limitation du courant de base négatif $I_{B2}$.

Le mode de réalisation détaillé décrit ci-dessus en relation avec les figures 3 et 4 ne constitue qu'un exemple de réalisation de la présente invention. Il est clair que, par exemple dans le cas d'une réalisation sous forme de circuit intégré, de nombreux éléments de circuit seront modifiés. Par exemple, un montage en source de courant, dans une réalisation en circuit intégré, comprendra moins de résistances que cela n'est représenté. On utilisera plutôt des transistors de polarisation et de charge, éventuellement montés en diodes, éventuellement associés à des miroirs de courant fixant les intensités choisies, les surfaces de ces différents transistors étant choisies selon des rapports déterminés.

A titre d'exemple pratique de réalisation, on pourra choisir comme composants du circuit de la figure 4, pour commander un Darlington de type BUV 54, les éléments suivants :

résistances : R1 = 1,5 kohms

R2 = 120 ohms

R3 = 120 ohms

R5 = 33 ohms

R6 = 180 ohms

R8 = 1 ohm

condensateurs C1 = 10 nanofarads

9

C2 = 220 nanofarads

transistors T1, T3 : BDX 53

T2 : BDX 54

T4 : BD 242

Avec ces valeurs, le courant $I_{B1}$ est de l'ordre de 0,5 A alors que le courant $I_{B2}$ est, à son maximum, de l'ordre de 2A.

10

REVENDICATIONS.

1. Circuit de commande de base d'un transistor de puissance pour, quand un signal d'ordre de commutation (S) est dans un premier état, appliquer au transistor de puissance un courant de base ($I_{B1}$) d'une première polarité pour que ce transistor de puissance soit conducteur, puis, quand ce signal d'ordre passe du premier état à un deuxième état, appliquer au transistor de puissance un courant de base de polarité inverse ($I_{B2}$) pour bloquer rapidement le transistor de puissance, ce circuit de commande étant alimenté par une source de tension unique (Vcc), caractérisé en ce que :

- le courant de base d'une première polarité $I_{B1}$ est fourni par une première source de courant (R5, R6, R7, T4) connectée à la base du transistor de puissance (T) dont l'émetteur est relié à un premier transistor interrupteur (T3),

- le courant de base d'une seconde polarité $I_{B2}$ est fourni par une deuxième source de courant (R2, R3, R4, T2) connectée à l'émetteur du transistor de puissance (T) dont la base est reliée à un deuxième transistor interrupteur (T1),

- le premier transistor interrupteur (T3) est en série avec le circuit de polarisation (R5, R6) de la première source de courant,

- le deuxième transistor interrupteur (T1) est en série avec le circuit de polarisation (R2, R3) de la deuxième source de courant,

- le deuxième transistor interrupteur (T1) reçoit le signal d'ordre (S) et est connecté au premier transistor interrupteur (T3) pour que leurs états soient complémentaires.

2. Circuit de commande de base selon la revendication 1, dans lequel le transistor de puissance est du type NPN, caractérisé en ce que les premier et second transistors interrupteurs sont de type NPN et en ce que les première et seconde sources de courant comprennent des transistors de type PNP.

11

3. Circuit de commande de base selon la revendication 2, caractérisé en ce que chacune des sources de courant comprend un transistor PNP dont l'émetteur est relié à la tension d'alimentation positive, dont le collecteur est relié à l'une des bornes de base ou d'émetteur du transistor de puissance, et dont la base est reliée à la tension d'alimentation par une première résistance (respectivement R2 et R5) et au collecteur du transistor interrupteur correspondant par une deuxième résistance (respectivement R3 et R6).

4. Circuit de commande de base selon la revendication 2, caractérisé en ce que la base du premier transistor interrupteur (T3) est reliée au collecteur du second transistor interrupteur (T1) par l'intermédiaire d'un circuit parallèle résistance/capacité (R1-C1).

5. Circuit de commande de base selon la revendication 3, caractérisé en ce que la base du transistor PNP (T4) de la première source de courant est reliée au collecteur du premier transistor interrupteur (T3) par l'intermédiaire du montage en parallèle d'une résistance (R6) et d'un condensateur (C2).

6. Circuit de commande de base selon la revendication 3, caractérisé en ce que les émetteurs des transistors PNP (T2 et T4) des première et deuxième sources de courant sont interconnectés et reliés à la borne d'alimentation positive (Vcc) par l'intermédiaire d'une même résistance (R8).

0119904

1/2

Fig.1A

Fig.1B

Fig.2

Fig.3

Fig.4

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | FR-A-2 311 452 (THOMSON-CSF) <br> * Page 2, ligne 13 - page 3; figure 1 * | 1 | H 03 K 17/04 |
| A | DE-B-1 176 191 (ALBISWERK ZÜRICH AG) <br> * Colonne 2, ligne 46 - colonne 4, ligne 4; figure 2 * | 1 | |

DOMAINES TECHNIQUES
RECHERCHES (Int. Cl. ³)

H 03 K
H 02 M

Le présent rapport de recherche a été établi pour toutes les revendications

| Lieu de la recherche <br> LA HAYE | Date d'achèvement de la recherche <br> 08-06-1984 | Examinateur <br> CANTARELLI R.J.H. |
|---|---|---|